# EUROPEAN PATENT APPLICATION

(11) **EP 1 178 613 A1**
(43) Date of publication of application: **06.02.2002**
(21) Application number: 00116611.5
(22) Date of filing: 01.08.2000
(51) Int. Cl.: H03M 13/39, H03M 13/29

(54) **Apparatus and method for determining an abort criterion in an iterative detection process**

(71) Applicant: MOTOROLA, INC., Schaumburg, IL 60196 (US)
(72) Inventor: Chass, Amir, 47204 Ramat Hasharon (IL); Gubeskys, Arik, 48600 Rosh Haayn (IL)
(74) Representative: Richardt, Markus Albert

(57) **Abstract**

A method and apparatus for determining an adaptive abort criterion in an iterative decoding process, an iterative step of the iterative decoding process involves calculating a plurality of approximations AP(1)...AP(N) of results R(1)..R(N), each result reflecting a first relationship between at least two elements X(1) and Y(1) .... X(N) and Y(N), accordingly, X(n) substantially equals EXP(-a(n)), Y(n) substantially equals EXP(-b(n)), 0<n<N+1, the method comprising the steps of : (A) performing an iteration step of the iterative decoding process on information to be decoded, wherein during said iteration step comparing a threshold to a first decision about a second relationship between a(j) and b(j), 0<j<N+1, to generate a comparison result; and (B) aborting the iterative decoding process dependent on the comparison result.

## Description

### FIELD OF THE INVENTION

Apparatus and method for determining an abort criterion in an iterative detecting process, such as a decoding process and an equalization process, and especially an apparatus and method for determining an adaptive abort criteria in a turbo detecting process.

### BACKGROUND OF THE INVENTION

Turbo Coding (i.e.- TC) is used for error control coding in digital communications and signal processing. The following references give some examples of various implementations of the TC: "Near Shannon limit error correcting coding and decoding: turbo-codes", by Berrou, Glavieux, Thitimajshima, IEEE International Conference of Communication. Geneva Switzerland, pp. 1064-1070, May 1993; "Implementation and Performance of a Turbo/MAP Decoder", Pietrobon, International Journal of Satellite Communication; "Turbo Coding", Heegard and Wicker, Kluwer Academic Publishers 1999.

MAP algorithm and soft output Viterbi algorithm (SOVA) are Soft Input Soft Output (i.e.- SISO) decoding and equalization algorithms that have gained wide acceptance in the area of communications. Both algorithms are mentioned in U.S patent 5,933,462 of Viterbi et al.

The TC has gained wide acceptance in the area of communications, such as in cellular networks, modems, and satellite communications. Some turbo encoders consists of two parallel-concatenated systematic convolutional encoders separated by a random interleaver. A turbo decoder has two soft-in soft-out (SISO) decoders. The output of the first SISO is coupled to the input of the second SISO via a first interleaver, while the output of the second SISO is coupled to an input of the first SISO via a feedback loop that includes a deinterleaver.

A common SISO decoder uses either a maximum a posteriori (i.e.- MAP) decoding algorithm or a Log MAP decoding algorithm. The latter algorithm is analogues to the former algorithm but is performed in the logarithmic domain. Another common decoding algorithm is the max log MAP algorithm. The log MAP is analogues to the log MAP but the implementation of the former involves an addition of correction factor. Briefly, the MAP finds the most likely information bit to have been transmitted in a coded sequence.

The output signals of a convolutional encoder are transmitted via a channel and are received by a receiver that has a turbo decoder. The channel usually adds noise to the transmitted signal.

During the decoding process a trellis of the possible states of the coding is defined. The trellis includes a plurality of nodes (states), organized in T stages, each stage has N=2sup(K-1) nodes, whereas T being the number of received samples taken into account for evaluating which bit was transmitted from a transmitter having the convolutional encoder and K is the constraint length of the code used for encoding. Each stage is comprised of states that represent a given time. Each state is characterized by a forward state metric, commonly referred to as alpha (α or a) and by a backward state metric, commonly referred to as beta (β or b). Each transition from a state to another state is characterized by a branch metric, commonly referred to as gamma (γ).

Alphas, betas and gammas are used to evaluate a probability factor that indicates which signal was transmitted. This probability factor is commonly known as lambda (Λ). A transition from a stage to an adjacent stage is represented by a single lambda.

Turbo decoding and turbo equalization are iterative detection processes comprising of a plurality of iterative steps. The number of iterative steps is usually a trade off between error correction performance and energy consumption. When decoding a plurality of information blocks some will be correctly decoded after a few iterations while other blocks will require more iterations. Accordingly there is a need to provide an abort criteria that will find the best trade off between performance and energy and time consumption.

Two types of prior art methods dealt with the problem of finding such an abort criteria. A first type prior art method is based upon an analysis of a Cyclic Redundancy Check portion of an information block. Said prior art method delays the decoding process because a check can be made only after a block is decoded. Furthermore, said method is not applicable to various methods of decoding in which said CRC portion is not decoded with the whole information block on which it was calculated. A second type prior art method comprises of the following methods : Cross Entropy method, Sign Change Ratio method and Hard Decision Aided method. Said methods are based upon a comparison between the extrinsic output or a hard decision of a current iteration and between an extrinsic output or hard decision of a previous iteration. Said methods are relatively complex, delay the decoding process and are memory consuming.

There is a need of an improved apparatus and method for determining an abort criterion in an iterative decoding process, that overcome the disadvantages of prior art methods and allows a fast and efficient decoding process.

### BRIEF DESCRIPTION OF THE DRAWINGS

While the invention is pointed out with particularity in the appended claims, other features of the invention are disclosed by the following detailed description taken in conjunction with the accompanying drawings, in which:
FIG. 1 is a graph illustrating a portion of a MAX*(a(n), b(n)) function and its linear approximation.
FIG. 2 is a flow chart illustrating a method for determining an abort criterion in an iterative decoding process, according to a preferred embodiment of the invention.
FIG. 3 is a flow charts illustrating a sub steps of calculating a path metric according to a Log Map algorithm and in association with the method for determining an abort criteria, according to a preferred embodiment of the invention;
FIG. 4 is a schematic description of an apparatus for determining an abort criterion in an iterative decoding process, according to a preferred embodiment of the invention; and
FIG. 5 is a schematic description of a portion of an apparatus for determining an abort criterion in an iterative decoding process, according to a preferred embodiment of the invention.

### DETAILED DESCRIPTION OF THE DRAWINGS

It should be noted that the particular terms and expressions employed and the particular structural and operational details disclosed in the detailed description and accompanying drawings are for illustrative purposes only and are not intended to in any way limit the scope of the invention as described in the appended claims.

The invention provides an efficient and fast method for determining an adaptive abort criterion in an iterative decoding process. Said abort criteria is calculated during each iterative step. The decision of whether to abort the iterative decoding process can be made in many occasions during an iterative step. Even when such a determination is made after the iterative step said determination is very fast and usually involves a comparison of a number to a threshold. Accordingly said method does not delay the decoding process.

The invention provides an efficient and fast method for determining an adaptive abort criterion in an iterative decoding process. Said abort criteria is based only upon the products of an iterative step, it does not depend upon any product of a previous iteration step. Furthermore, there is no need to store any product of the iterative step, except a single indication. Accordingly, said apparatus and method are memory efficient.

The invention provides an efficient and fast method for determining an adaptive abort criterion in an iterative decoding process, an iterative step of the iterative decoding process involves calculating a plurality of approximations AP(1)...AP(N) of results R(1)..R(N), each result reflecting a first relationship between at least two elements X(1)...X(N) and Y(1)..Y(N) accordingly, X(n) substantially equals EXP(a(n)), Y(n) substantially equals EXP(b(n)), 0<n<N+1, the method comprising the steps of : (A) Performing an iteration step of the iterative decoding process on information to be decoded, wherein during said iteration step comparing a threshold to a first decision about a second relationship between a(j) and b(j), 0<j<N+1, to generate a comparison result; and (B) Aborting the iterative decoding process dependent on the comparison result.

Conveniently, the invention provides an efficient and fast method for determining an adaptive abort criterion in an iterative decoding process, in which a second relationship between each pair of a(j) and b(j) is an absolute value of a difference d(j) between a(j) and b(j). The first decision reflects a number of times d(j) is smaller than the threshold. The first relationship between X(n) and Y(n) is the difference between X(n) and Y(n). An iterative step produces a soft output. Usually, AP(n) is either a linear approximation of R(n), a step approximation of R(n) or a multiple step approximation of R(n). When AP(n) equals MAX{0, (DE-(a(n)-b(n))/E)} the threshold substantially equals DE. The threshold substantially equals G when AP(n) equals a first value if (a(n)-b(n)) is smaller than or equal to G, and a second value when (a(n)-b(n)) is greater than G.

Conveniently, the invention provides an efficient and fast method for determining an adaptive abort criterion in an iterative decoding process, the iterative decoding process is a turbo decoding process. The iterative step implements an algorithm selected from a group of log-MAP algorithm and Max-Log-MAP algorithm. The iterative step involves calculating a plurality of a MAX*(a(n), b(n)) functions. The calculation of a MAX*(a(n), b(n)) function is based upon approximation AP(n). MAX*(a(n), b(n)) = MAX(a(n), b(n)) + Log(1+EXP{-|a(n)-b(n)|}).

Conveniently, the invention provides an efficient and fast method for determining an adaptive abort criterion in an iterative decoding process, whereas information to be decoded is a trellis having K stages, each stage having L nodes. The decoding process involves calculating alphas, betas and gammas. The calculation of alphas and betas usually requires N (N= K*L) MAX* function calculations.

The invention provided a method for determining an abort criteria whereas said method further comprising a step of aborting the iterative decoding when a number of iterations already completed corresponds to a predetermined number if the iterative decoding is not already aborted as a result of a comparison result.

MAX(a(n),b(n)) function outputs a maximum of a(n) and b(n).

|a(n)-b(n)| equals an absolute value of a difference between a(n) and b(n).

EXP(a(n)) means e by the power of a(n).

For convenience of explanation, the following description relates to turbo decoding, and to either Log MAP and Max Log MAP algorithms. The invention is not limited to said decoding methods or to said algorithms. For example said invention is also applied in various detection processes such as equalization processes.

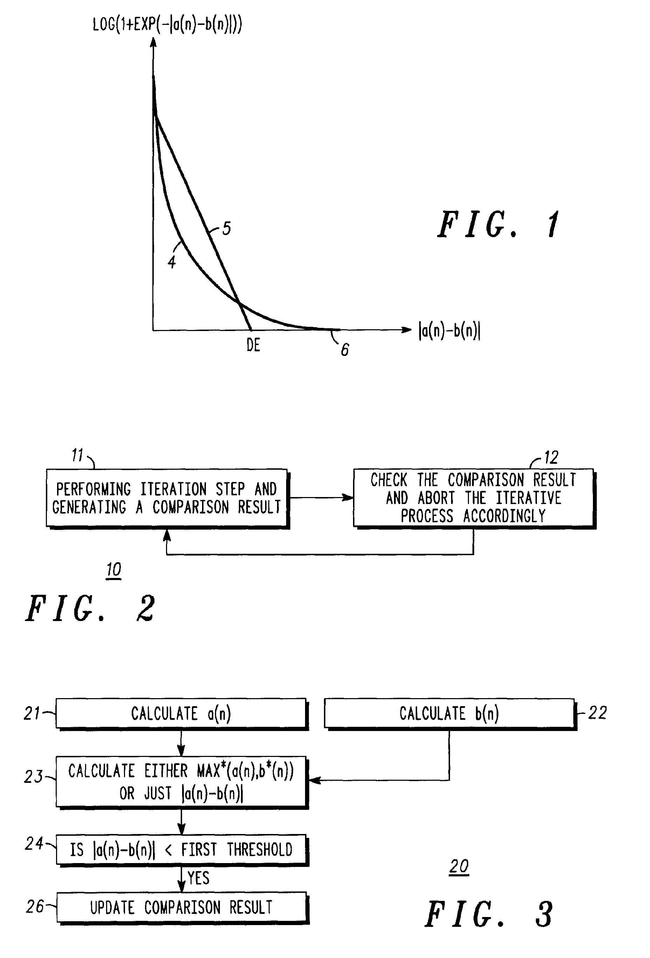

FIG. 1 is a graph illustrating a portion of a MAX*(a(n), b(n)) versus an absolute value of a difference between a(n) and b(n). Said graph further illustrates a linear approximation of said portion. Said portion equals Log(1+EXP{-|a(n)-b(n)|}). Curved line 4 illustrates portion Log(1+EXP{-|a(n)-b(n)|}), while line 5 illustrates a linear approximation of said portion. Line 5 crosses a horizontal graph line 6 at point DE. Conveniently the threshold substantially equals DE.

FIG. 2 is a flow chart illustrating a method 10 for determining an abort criterion in an iterative decoding process, according to a preferred embodiment of the invention.

Method 10 comprising of steps 11 and 12. Step 11 of performing an iteration step of an iterative decoding process on information to be decoded, the iterative step of the iterative decoding process involves calculating a plurality of approximations AP(1)...AP(N) of results R(1)..R(N), each result reflecting a first relationship between at least two elements X(1)...X(N) and Y(1)..Y(N) accordingly, X(n) substantially equals' EXP(a(n)), Y(n) substantially equals EXP(b(n)), 0<n<N+1. During said iteration step comparing a threshold to a first decision about a second relationship between a(j) and b(j), 0<j<N+1, to generate a comparison result.

Step 12 of aborting the iterative decoding process dependent on the comparison result.

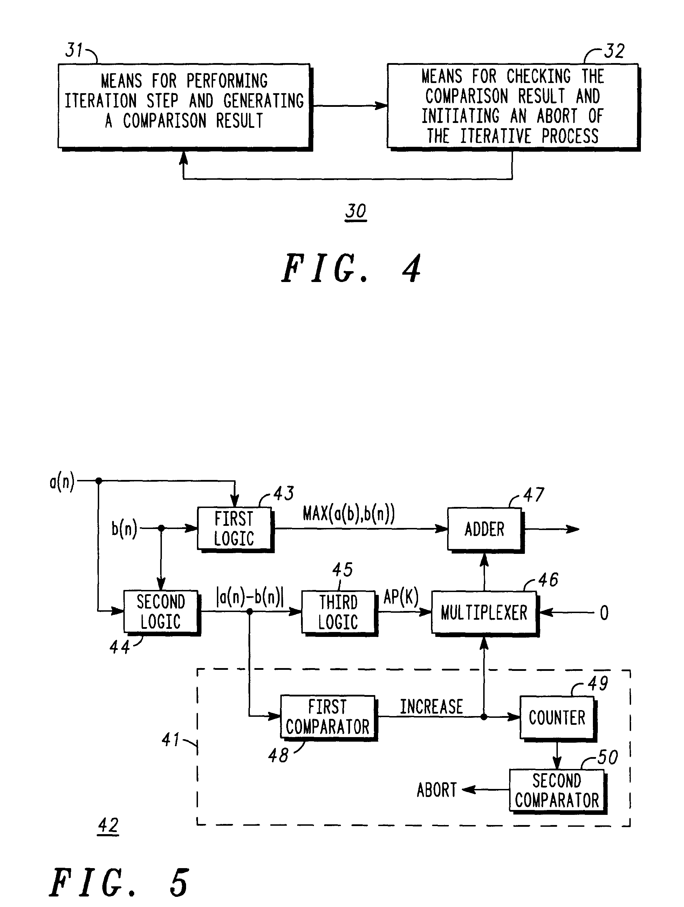

Referring to Fig. 3 illustrating sub-step 20 of calculating a path metric according to a Log Map algorithm and in association with the method for determining an abort criteria, according to a preferred embodiment of the invention. During an iteration step the path metrics of at least a portion of a trellis are calculated. Said calculation is based upon a MAX*(a(n), b(n)) function. Whereas a(n) equals a sum of a first previous stage path metric and a first current branch metrics, said first previous stage path metrics represents a first node of the previous stage and the branch metrics represents a link between said first node and a first node of a current metrics. Whereas b(n) equals a sum of a second previous stage path metric and a second current branch metrics, said second previous stage path metrics represents a second node of the previous stage and the second branch metrics represents a link between said second node and the first node of a current metrics. Said MAX* function equals MAX(a(n), b(n)) + Log(1+EXP{-|a(n)-b(n)|}). Said function is calculated by calculating the MAX(a(n), b(n)) and calculating a linear approximation of Log(1+EXP{-|a (n)-b(n)|}).

Sub-step 20 starts at steps 21 and 22 of calculating a(n) and b(n). Conveniently, steps 21 and 22 are executed in parallel and both are followed by step 23 of calculating an approximation of MAX*(a(n),b(n)) or at least calculating |a(n)-b(n)|. Step 23 is followed step 24 of by comparing |a(n)-b(n)| to a threshold and updating (step 25) a comparison result accordingly. If |a(n)-b(n)| is smaller than said threshold then said comparison result is increased. If during an iterative step the comparison result is smaller than a second threshold than the iteration step is stopped.

The computation result can be calculated whenever either alphas, betas and/or lambdas are calculated - during either a forward recursion stage, during a forward recursion stage and even during the soft decisions stage.

FIG. 4 is a schematic description of an apparatus 30 for determining an abort criterion in an iterative decoding process, according to a preferred embodiment of the invention. Apparatus 30 comprising means 31 for performing an iteration step of the iterative decoding process on information to be decoded, said means for performing an iteration step further comprising a comparing means for comparing a threshold to a first decision about a second relationship between a(j) and b(j), 0<j<N+1, to generate a comparison result; and means 32 for initiating an abort of the iterative decoding process dependent on the comparison result.

For example, when a turbo decoder is implemented,
means 31 can be either one of the soft input soft output SISO decoders, while means 32 is a control unit that is coupled to both SISO decoders, and is adapted to stop either one or both SISO decoders.

FIG. 5 is a schematic description of a portion 41 of an apparatus 30 for determining an abort criterion in an iterative decoding process, according to a preferred embodiment of the invention.

Said portion 41 is a part of a unit 42 for calculating MAX*(a(n),b(n)). Unit 42 comprising a first logic 43 for calculating MAX(a(n), b(n)), a second logic 44 for calculating |a(n)-b(n)|, a third logic 45 for calculating an approximation to Log(1+EXP{-|a(n)-b(n)|}), a multiplexer 46, an adder 47. Unit 42 comprising a first comparator 48, a counter 49 and a second comparator 50.

First logic 43 and second logic 44 receive a(n) and b(n). First logic provides MAX(a(n),b(n)) to a first input of adder 47. Second logic 44 provides |(a(n)-b(n)| to both third logic 45 and first comparator 48. Third logic receives |a(n)-b(n)| and accordingly generates an approximation and provides said approximation to a first input of multiplexer 46. First comparator 48 compares |a(n)-b(n)| to a first threshold and if it is smaller than said threshold it sends an INCREASE signal to counter 49 that causes counter 49 to count up. INCREASE signal is also provided to multiplexer 46 for selecting whether to provide "0" or the approximation of Log(1+EXP{-|a(n)-b(n)|}), to a second input of adder 47, to be added to MAX(a(n),b(n)) and to provide a product of a MAX*(a(n),b(n)) function. The content of counter 49 is compared to a second threshold to generate a comparison result. Counter 49 is reset periodically, after a predetermined amount of MAX* function calculations are performed.

It should be noted that the particular terms and expressions employed and the particular structural and operational details disclosed in the detailed description and accompanying drawings are for illustrative purposes only and are not intended to in any way limit the scope of the invention as described in the appended claims.

Thus, there has been described herein an embodiment including at least one preferred embodiment of a device and method for determining an abort criterion in an iterative decoding process.

It will be apparent to those skilled in the art that the disclosed subject matter may be modified in numerous ways and may assume many embodiments other than the preferred form specifically set out and described above.

Accordingly, the above disclosed subject matter is to be considered illustrative and not restrictive, and to the maximum extent allowed by law, it is intended by the appended claims to cover all such modifications and other embodiments which fall within the true spirit and scope of the present invention. The scope of the invention is to be determined by the broadest permissible interpretation of the following claims and their equivalents rather than the foregoing detailed description.

## Claims

1. A method for determining an adaptive abort criterion in an iterative detection process, an iterative step of the iterative detection process involves calculating a plurality of approximations AP(1)...AP(N) of results R(1)..R(N), each result reflecting a first relationship between at least two elements, X(1) and Y(1) ... X(N) and Y(N) accordingly, X(n) substantially equals EXP(a(n)), Y(n) substantially equals EXP(b(n)), 0<n<N+1, the method comprising the steps of :
performing an iteration step of the iterative
detection process on
information to be detected, wherein during said iteration step comparing a threshold to a first decision about a second relationship between a(j) and b(j), 0<j<N+1, to generate a comparison result; and
aborting the iterative detection process dependent on the comparison result.

2. The method of claim 1 wherein the iterative detection process is an iterative decoding process.

3. The method of claim 1 wherein the iterative detection process is an iterative equalization process.

4. The method of claim 1 wherein a second relationship between a(j) and b(j) is an absolute value of a difference d(j) between a(j) and b(j).

5. The method of claim 4 wherein the first decision reflects a number of times d(j) is smaller than the threshold.

6. The method of claim 1 wherein a first relationship between X(n) and Y(n) is a sum of X(n) and Y(n).

7. The method of claim 1 wherein aborting the iterative detection process when the comparison result is smaller than a second threshold.

8. The method of claim 1 wherein an iterative step produces a soft output.

9. The method of claim 1 whereas AP(n) is a linear approximation of R(n).

10. The method of claim 9 wherein AP(n) equals MAX{0,(D-(a(n)-b(n))/E)} and the threshold substantially equals DE.

11. The method of claim 1 whereas AP(n) is a step approximation of R(n).

12. The method of claim 11 wherein AP(n) equals a first value if (a(n)-b(n)) is smaller than or equal to G, and a second value when (a(n)-b(n)) is greater than G, and wherein the threshold is substantially equal to G.

13. The method of claim 1 whereas AP(n) is a multiple step approximation of R(n).

14. The method of claim 13 wherein a look up table maps a relationship between a(n) and b(n) to AP(n).

15. The method of claim 1 whereas the iterative detection process is a turbo decoding process.

16. The method of claim 1 further comprising the step of aborting the iterative detection process when a number of iterations already completed corresponds to a predetermined number if the iterative detection process is not already aborted as a result of a comparison result.

17. The method of claim 1 wherein the iterative step implements an algorithm selected from a group of log-MAP algorithm and Max-Log-MAP algorithm.

18. The method of claim 17 wherein the first decision relates to calculations of approximations during a single forward recursion stage.

19. The method of claim 17 wherein the first decision relates to calculations of approximations during a single backward recursion stage.

20. The method of claim 17 wherein the first decision relates to calculations of approximation during a single soft output stage.

21. The method of claim 1 whereas an iterative step of the iterative detection process involves calculating a plurality of a MAX*(a(n), b(n)) functions.

22. The method of claim 20 whereas the calculation of a MAX*(a(n), b(n)) function is based upon approximation AP(n).

23. The method of claim 21 whereas MAX*(a(n), b(n)) = MAX(a(n), b(n)) + Log(1+EXP{-|a(n)-b(n)|}).

24. The method of claim 1 wherein information to be detected has a trellis having K stages, each stage having L nodes.

25. The method of claim 1 wherein N equals K*L.

26. The method of claim 1 wherein the iterative detection process is a turbo equalization process.

27. An apparatus for determination of an adaptive abort criterion in an iterative detection process, an iterative step of the iterative decoding process involves calculating a plurality of approximations AP(1)...AP(N) of results R(1)..R(N), each result reflecting a first relationship between at least two elements X(1)...X(N) and Y(1)..Y(N) accordingly, X(n) substantially equals EXP(a(n)), Y(n) substantially equals EXP(b(n)), 0<n<N+1, the device comprising of :
means for performing an iteration step of the
iterative detection process
on information to be detected, said means for performing an iteration step further comprising a comparing means for comparing a threshold to a first decision about a second relationship between a(j) and b(j), 0<j<N+1, to generate a comparison result; and
means for initiating an abort of the iterative detection process dependent on the comparison result.

28. The apparatus of claim 27 wherein the iterative detection process is an iterative decoding process.

29. The apparatus of claim 27 wherein the iterative detection process is an iterative equalization process.

30. The apparatus of claim 27 wherein a second relationship between a(j) and b(j) is an absolute value of a difference d(j) between a(j) and b(j).

31. The apparatus of claim 30 wherein the first decision reflects a number of times d(j) is smaller than the threshold.

32. The apparatus of claim 27 wherein a first relationship between X(n) and Y(n) is a sum of X(n) and Y(n).

33. The apparatus of claim 27 wherein aborting the iterative detecting process when the comparison result is smaller than a second threshold.

34. The apparatus of claim 27 wherein an iterative step produces a soft output.

35. The apparatus of claim 27 whereas AP(n) is a linear approximation of R(n).

36. The apparatus of claim 35 wherein AP(n) equals MAX{0,(DE-(a(n)-b(n))/E)} and the threshold substantially equals DE.

37. The apparatus of claim 36 whereas AP(n) is a step approximation of R(n).

38. The apparatus of claim 37 wherein AP(n) equals a first value if (a(n)-b(n)) is smaller than or equal to G, and a second value when (a(n)-b(n)) is greater than G, and wherein the threshold is substantially equal to G.

39. The apparatus of claim 38 whereas AP(n) is a multiple step approximation of R(n).

40. The apparatus of claim 39 wherein a look up table maps a difference between a(n) and b(n) to AP(n).

41. The apparatus of claim 40 whereas the iterative detection process is a turbo decoding process.

42. The apparatus of claim 41 further comprising the step of aborting the iterative decoding when a number of iterations already completed corresponds to a predetermined number if the iterative decoding is not already aborted as a result of a comparison result.

43. The apparatus of claim 42 wherein the iterative step implements an algorithm selected from a group of log-MAP algorithm and Max-Log-MAP algorithm.

44. The apparatus of claim 43 wherein the first decision relates to calculations of approximations during a single forward recursion stage.

45. The apparatus of claim 43 wherein the first decision relates to calculations of approximations during a single backward recursion stage.

46. The apparatus of claim 45 wherein the first decision relates to calculations of approximation during a single soft output stage.

47. The apparatus of claim 37 whereas an iterative step of the iterative detection process involves a calculating a plurality of a MAX*(a(n), b(n)) functions.

48. The apparatus of claim 47 whereas the calculation of a MAX*(a(n), b(n)) function is based upon approximation AP(n).

49. The apparatus of claim 48 whereas MAX*(a(n), b(n)) = MAX(a(n), b(n)) + Log(1+EXP{-|a(n)-b(n)|}).

50. The apparatus of claim 49 wherein information to be detected has a trellis having K stages, each stage having L nodes.

51. The apparatus of claim 27 wherein N equals K*L.
